(19) **Europäisches Patentamt / European Patent Office / Office européen des brevets**

(11) **EP 1 920 263 B1**

(12) **EUROPÄISCHE PATENTSCHRIFT**

(45) Veröffentlichungstag und Bekanntmachung des Hinweises auf die Patenterteilung:
**06.04.2011   Patentblatt 2011/14**

(21) Anmeldenummer: **06754013.8**

(22) Anmeldetag: **31.05.2006**

(51) Int Cl.:
***G01R 31/28*** *(2006.01)*      ***G01R 31/312*** *(2006.01)*

(86) Internationale Anmeldenummer:
**PCT/EP2006/005193**

(87) Internationale Veröffentlichungsnummer:
**WO 2006/133808 (21.12.2006 Gazette 2006/51)**

(54) **VERFAHREN ZUM TESTEN VON UNBESTÜCKTEN, GROSSFLÄCHIGEN LEITERPLATTEN MIT EINEM FINGERTESTER**

METHOD OF TESTING UNLOADED, LARGE-AREA PRINTED CIRCUIT BOARDS WITH A FINGER TESTER

PROCEDE POUR TESTER DES CARTES DE CIRCUITS IMPRIMES DE GRANDES SURFACES NON EQUIPEES, AU MOYEN D'UN TESTEUR A PATTES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **17.06.2005   DE 102005028191**

(43) Veröffentlichungstag der Anmeldung:
**14.05.2008   Patentblatt 2008/20**

(73) Patentinhaber: **DTG International GmbH 8005 Zürich (CH)**

(72) Erfinder:
• **YANENKO, Evgeny**
  **97877 Wertheim-Dörlesberg (DE)**
• **VOLPERT, Gilbert**
  **97877 Wertheim-Reicholzheim (DE)**
• **ROTHAUG, Uwe**
  **97828 Marktheidenfeld (DE)**

(74) Vertreter: **Ganahl, Bernhard et al Huber & Schüssler Patentanwälte Truderinger Strasse 246 81825 München (DE)**

(56) Entgegenhaltungen:
**EP-A- 0 468 153      EP-A- 0 772 054
WO-A-01/40809      DE-A1- 19 821 225
US-A- 3 975 680      US-A- 4 565 966
US-A- 5 045 783**

EP 1 920 263 B1

**Beschreibung**

Die vorliegende Erfindung betrifft ein Verfahren zum Testen von unbestückten, großflächigen, Leiterbahnen aufweisenden Leiterplatten mit einem Fingertester.

Vorrichtung zum Testen von unbestückten Leiterplatten können grundsätzlich in zwei Gruppen eingeteilt werden, nämlich den Fingertestern und den Paralleltestem.

Paralleltester sind Prüfvorrichtungen, die mittels einer Kontaktanordnung, die in der Regel durch einen Adapter dargestellt wird, alle oder zumindest die meisten Kontaktstellen einer zu prüfenden Leiterplatte gleichzeitig kontaktieren. Derartige Paralleltester werden bevorzugt zum Testen von unbestückten Leiterplatten verwendet, da mit ihnen eine große Anzahl von Leiterplattentestpunkten schnell und sicher abgetastet werden kann.

Aus der WO 01/40809 A1 geht ein Verfahren hervor, mit welchem Bereiche von Leiterplatten aufeinander folgend getestet werden, wobei die einzelnen Bereiche sich derart überlappen müssen, dass Leiterbahnen, die sich von einem Bereich in einen anderen Bereich erstrecken im Überlappungsbereich einen Kontaktpunkt aufweisen. Hierdurch ist es möglich, derartige Leiterbahnen abschnittsweise auf Unterbrechungen zu testen.

Aus der US 5,045,783 geht die Verwendung eines Rasterelektronenmikroskops zum Testen von großen Leiterplatten hervor. Mit dem Verfahren können Unterbrechungen auf Leiterplatten festgestellt werden. Das Abtastfeld des Rasterelektronenmikroskopes ist aber infolge eines Ablenkfarbfehlers und der mit dem Ablenkwinkel stark anwachsenden Aberationen der Objektivlinse begrenzt. Der Elektronenstrahl kann also nur in einem engen Bereich Potentiale auf einer isolierten Leiterplatte aufbringen und lesen. Damit auch größere Leiterplatten getestet werden können, erfolgt eine Unterteilung in Felder, deren Größe annähernd der Größe des maximalen Abtastbereichs entspricht. Unterbrechungen werden nachgewiesen, indem ein Kontaktpunkt eines Netzwerkes aufgeladen wird und anschließend die zugehörigen Kontaktpunkte innerhalb desselben Netzwerks gemessen werden. Sind die Kontaktpunkte nicht geladen, liegt eine Unterbrechung vor. Um Unterbrechungen auf Leiterbahnen die sich über mehrere Felder erstrecken, festzustellen, ist ein weiterer Testzyklus erforderlich. Dabei wird, im Falle von zwei Testbereichen, der erste Bereich im Abtastfeld des Elektronenstrahlmessgeräts positioniert und alle in ihm enthaltenen Kontaktpunkte aufgeladen. Im Anschluss wird dann der zweite Bereich mit dem Abtastfeld zur Deckung gebracht und die Ladungszustände der Kontaktpunkte werden mit einer Elektronensonde getestet. Der gemessene Ladungszustand wird dann mit dem, aufgrund der Netzwerkgeometrie, erwarteten Ladungszustand verglichen. Ist keine Ladung vorhanden liegt eine Unterbrechung vor. Das Testen weiterer Felder erfolgt analog. Allerdings müssen vorher die Bereiche entladen werden.

Ein Fingertester ist beispielsweise in der EP 0 468 153 A1 beschrieben. Die Vorzüge der Fingertester liegen darin, dass sie sehr flexibel sind und unterschiedlichste Arten von Leiterplatten getestet werden können, ohne dass hierbei irgendwelche mechanischen Umbauten notwendig sind. Zudem können mit Fingertestern alle beliebigen Leiterplattentypen getestet werden.

Aus der US 3,975,680 und der EP 0 772 054 A2 ist es bekannt, Leiterbahnen auf Unterbrechungen durch Erfassen der elektrischen Kapazität der entsprechenden Leiterbahnen und durch Vergleich mit einem Referenzwert zu testen. Hieraus geht ein zweistufiges Prüfverfahren hervor, bei dem in der ersten Stufe eine Feldmessung ausgeführt wird, mit welcher komplexe Leitwerte für die einzelnen Leiterbahnen anhand einer ersten Leiterplatte ermittelt werden, und in der zweiten Stufe von weiteren Leiterplatten lediglich die Leitwerte gemessen werden und diese mit den mittels der Feldmessung ermittelten Leitwerte verglichen werden. Bei der Feldmessung werden elektrische Felder angelegt und die induzierten Potentiale bzw. Spannung in den Leiterbahnen gemessen. Als Antennen zum Erzeugen der elektrischen Felder können Leiterbahnen verwendet werden. Da diese elektrischen Felder nur einen räumlich begrenzten Wirkungsbereich aufweisen, kann die Feldmessung segmentweise ausgeführt werden, indem eine oder mehrere Leiterbahnen eines bestimmen Bereiches der Leiterplatte als Antennen zum Erzeugen eines elektrischen Feldes verwendet werden und die in der Umgebung dieser Antennen liegenden Leiterbahnen gemessen werden.

Es gibt seit langem am Markt Testvorrichtungen, bei welchen an allen Leiterplattentestpunkten einer Leiterbahn die Kapazität gemessen wird und falls diese Kapazitätswerte alle gleich sind und noch mit einem vorbestimmten Referenzwert übereinstimmen, dann weisen diese Leiterbahnen keine Unterbrechung auf.

Aus der US 4,565,966 A geht ein Verfahren und eine Vorrichtung zum Prüfen von Leiterplatten hervor, bei welchen sowohl der elektrische Widerstand als auch die elektrische Kapazität der einzelnen Leiterbahnen gemessen und mit entsprechenden Soll-Werten verglichen werden. Liegen Abweichungen über eine vorbestimmten Betrag vor, so wird dies als Fehler festgestellt.

Zum Testen von unbestückten, großflächigen Leiterplatten gibt es spezielle Fingertester, die einen entsprechend großen Testbereich besitzen. So bietet die Firma MicroCraft K.K. unter der Handelsbezeichnung EM12181 einen Fingertester an, der einen Arbeitsbereich von 800 mm x 1200 mm besitzt. Die Firma Mania Technology AG bietet unter der Handelsbezeichnung Speedy 580 XXL einen Fingertester an, der Leiterplatten bis zu einer maximalen Größe von 980 mm x 650 mm testen kann. Diese extra-großen Fingertester sind aufgrund ihrer geringen Stückzahl sehr teuer in ihrer Entwicklung, Produktion und im Betrieb. Zum Testen von extra-großen Leiterplatten mit einer Kantenlänge von mehr als 500 mm sind derartige Testvorrichtungen notwendig, da auch diese Leiterplatten zuverlässig getestet werden müssen.

Es besteht daher ein erheblicher Bedarf nach einer kostengünstigen Lösung zum Testen von unbestückten, großflächigen Leiterplatten.

Der Erfindung liegt die Aufgabe zugrunde, ein Verfahren zum Testen von unbestückten, großflächigen, Leiterbahnen aufweisenden Leiterplatten zu schaffen, das mit einer kostengünstigen Testvorrichtung ausführbar ist und mit dem die Leiterbahnen zuverlässig getestet werden können.

Die Aufgabe wird durch ein Verfahren mit den Merkmalen des Anspruchs 1 gelöst. Vorteilhafte Ausgestaltungen sind in den Unteransprüchen angegeben.

Beim erfindungsgemäßen Verfahren zum Testen von unbestückten großflächigen Leiterbahnen aufweisenden Leiterplatten wird ein Fingertester verwendet, wobei

- die Leiterplatte in mehrere Segmente unterteilt getestet wird, wobei die einzelnen Segmente aufeinanderfolgend in einem Testbereich des Fingertesters getestet werden, bis die vollständige Leiterplatte getestet worden ist, wobei der Testbereich der gesamte Bereich ist, der von Kontaktfingern des Fingertesters abgefahren werden kann und in dem Testelektroden der Kontaktfinger die Leiterplatte kontaktieren können, und die Leiterplatte größer als der Testbereich ist, und

- beim Testen jeweils eines Segmentes der Leiterplatte Leiterbahnen, die sich über das jeweilige zu testende Segment hinaus erstrecken, mittels kapazitiver Messung der in dem Segment befindlichen Endpunkte dieser Leiterbahnen auf Unterbrechungen getestet werden, wobei jeweils ein kapazitiver Messwert erfasst wird, nach dem abschließenden Testen des einen Segmentes die Leiterplatte weiterbewegt wird, um sie mit dem nächsten Segment im Testbereich zu positionieren

- alle zu einer Leiterbahn gehörenden kapazitiven Messwerte jeweils eine Gruppe bilden und die kapazitiven Messwerte innerhalb einer jeden Gruppe miteinander verglichen werden, und falls sich zumindest ein kapazitiver Messwert von anderen kapazitiven Messwerten der jeweiligen Gruppe um einen vorbestimmten Wert unterscheidet, wird dies als Unterbrechung beurteilt.

Mit dem erfindungsgemäßen Verfahren können herkömmliche, in großen Stückzahlen hergestellte Fingertester mit einem typischen Testbereich von 600 mm x 600 mm verwendet werden. Das erfindungsgemäße Verfahren kann auch bei bereits vorhanden Fingertestern eingesetzt werden. Mit dem erfindungsgemäßen Verfahren können Leiterplatten getestet werden, die größer als der Testbereich des Fingertesters sind und z.B. eine Größe von 1.200 mm x 600 mm, 800 mm x 1.200 mm, 800 mm x 1.500 mm oder 600 mm x 800 mm aufweisen.

Beim erfindungsgemäßen Verfahren werden lange Leiterbahnen, die sich über mehrere Segmente erstrecken, mittels einer kapazitiven Messung auf Unterbrechungen getestet. Da bei einer kapazitiven Messung jeweils nur ein einziger Leiterbahnendpunkt zu kontaktieren ist, ist es möglich, beim Testverfahren mehrere Segmente der Leiterplatte unabhängig voneinander zu testen und danach die Messwerte, die zu einer Leiterbahn gehören gemeinsam auszuwerten. Der Erfindung liegt auch die Erkenntnis zugrunde, dass sich beim Vorliegen einer Unterbrechung und/oder eines hochohmigen Abschnittes in der Leiterbahn die Kapazität einer langen Leiterbahn deutlich ändert, so dass eine Unterbrechung mit einer kapazitiven Messung zuverlässig erfasst werden kann. Unterbrechungen im Sinne der vorliegenden Erfindung umfassen auch Abschnitte in den Leiterbahnen mit einem Widerstandswert von zumindest 1 Megaohm (1 MΩ) vorliegen.

Bei kleinen Leiterbahnen ist die kapazitive Messung auf Unterbrechungen nicht immer zuverlässig durchführbar. Kleine Leiterbahnen liegen jedoch meistens vollständig innerhalb der Segmente, weshalb diese dann herkömmlich mit einer Ohmschen-Messung auf Unterbrechungen untersucht werden können. Vorzugsweise sind die Segmente derart überlappend anzuordnen, dass alle kleinen Leiterbahnen bzw. abgreifbare Abschnitte kleiner Leiterbahnen vollständig innerhalb eines Segmentes angeordnet sind.

Die Erfindung wird nachfolgend beispielhaft näher anhand der Zeichnungen erläutert. In den Zeichnungen zeigen:

Fig. 1    schematisch den Aufbau eines Fingertesters,

Fig. 2    die Unterteilung einer zu testenden Leiterplatte in einzelne Testsegmente,

Fig. 3    das erfindungsgemäße Verfahren schematisch in einem Flussdiagramm, und

Fig. 4    schematisch den Aufbau einer Testvorrichtung mit einer automatischen För- dereinrichtung.

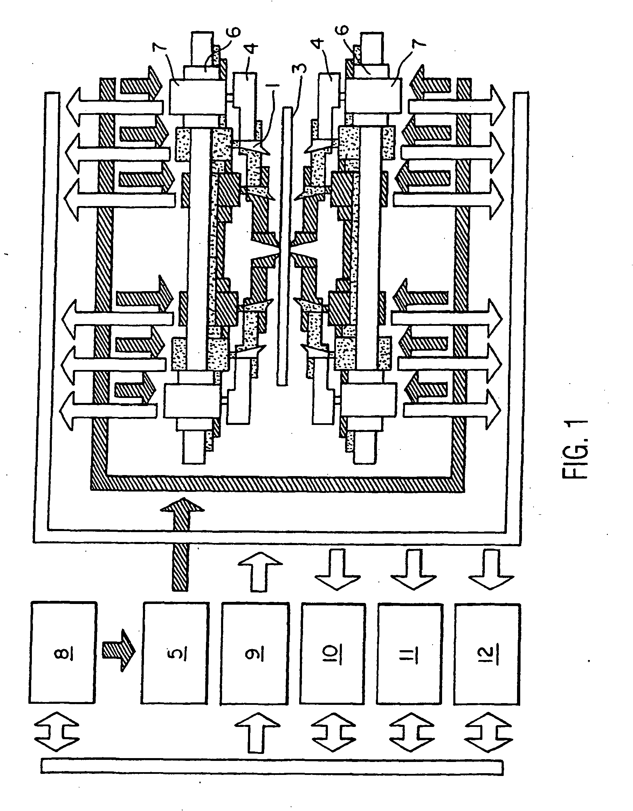

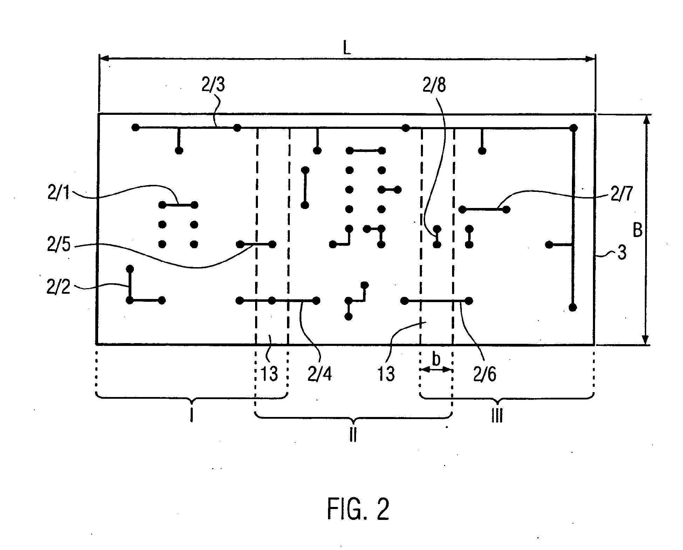

Das erfindungsgemäße Verfahren zum Testen von unbestückten, großflächigen, Leiterbahnen aufweisenden Leiterplatten wird in einem Fingertester ausgeführt. Ein Fingertester weist mehrere Testelektroden 1 auf, die mit Leiterplattentestpunkten der Leiterbahnen 2 einer Leiterplatte 3 kontaktiert werden können (Fig. 1; 2). Jeweils eine Testelektrode 1 ist in einem Kontaktfinger 4 integriert. Bei dem vorliegenden Fingertester handelt es sich um ein Multi-Finger-System, das insgesamt zwölf Kontaktfinger 4 aufweist, wobei jeweils sechs Kontaktfinger auf einer Seite der zu testenden Leiterplatte 3 angeordnet sind. Ein Fingertester, bei dem die Kontaktfinger unabhängig voneinander verfahrbar sind, ist in der EP 0 468 135 A1 beschrieben. Die Kontaktfinger 4 können parallel zur Oberfläche der Leiterplatte 3 verschoben werden, so dass die Testelektroden 1 mit bestimmten Leiterplattentestpunkten der Leiterbahnen kontaktiert werden können. Die Kontaktfinger 4 sind jeweils an einem durch eine Positionssteuereinrichtung 5 gesteuerten Schlitten 6 befestigt, der in einer Ebene parallel zur Leiterplatte 3 verfahren werden kann. Die Schlitten 6 sind jeweils mit einem vertikal ausgerichteten Stellzylinder 7 versehen, mit dem die Kontaktfinger 4 um die vertikale Achse gedreht werden können. Ferner ist an den Kontaktfingern 4 eine Kippeinrichtung integriert, so dass die Finger mit der an Ihren Spitzen angeordneten Testelektroden 1 auf die Leiterplatte 3 abgesenkt werden können.

Die Positionsteuereinrichtung 5 erhält zur Steuerung der Bewegung der Kontaktfinger 4 ihre Signale von einer zentralen Steuereinheit 8. Zur Erzeugung des Messsignals ist ein Funktionsgenerator 9 vorgesehen, der eine Messspannung mit bestimmter Amplitude $U_0$ und bestimmter Frequenz $f_0$ an die Testelektrode 1 eines Kontaktfingers 4 zum Einspeisen in eine Leiterbahn der zu testenden Leiterplatte 3 abgibt. Bei dem vorliegenden Ausführungsbeispiel liegt die Frequenz $f_0$ zwischen 0 und 2000 Hz.

Der Fingertester weist eine erste, zweite und dritte Auswerteeinrichtung 10, 11, 12 auf. Die erste Auswerteeinrichtung 10 dient zum Ausführen eines Unterbrechungstestes mittels einer Ohmschen-Messung. Hierbei werden zwei Leiterplattentestpunkte einer Leiterbahn von zwei Testelektroden 1 gleichzeitig kontaktiert und ein vom Funktionsgenerator 9 erzeugter Gleichstrom wird zwischen diesen beiden Testelektroden 1 angelegt. Die erste Auswerteeinrichtung 10 detektiert die zwischen den beiden Testelektroden 1 abfallende Spannung und ermittelt hieraus den elektrischen Widerstand dieser Leiterbahnen bzw. dieses Leiterbahnabschnittes. Liegt der Widerstand über einen vorbestimmten Schwellwert von z.B. 100 Ohm, so wird die Leiterbahn als eine Unterbrechung aufweisend beurteilt.

Die zweite Auswerteeinrichtung 11 dient zum Ausführen von Kurzschlusstests zwischen zwei Leiterbahnen, wobei hier wiederum eine Ohmsche-Messung zwischen zwei Leiterplattentestpunkten zweier unterschiedlicher Leiterbahnen ausgeführt wird. Liegt der ermittelte Widerstand unter einen vorbestimmten Schwellwert, von z.B. 100 MΩ, so wird dies als Kurzschluss zwischen den beiden Leiterbahnen beurteilt.

Der Kurzschlusstest kann anstelle einer Ohmschen-Messung auch mittels einer sogenannten Feldmessung ermittelt werden, wie sie in der US 3,975,680 bzw. der EP 0 772 054 A2 beschrieben ist, bei der anhand der gemessen komplexen Leitwerte der Leiterbahnen ermittelt werden kann, ob zwischen zwei Leiterbahnen ein Kurzschluss besteht.

Die dritte Auswerteeinrichtung 12 dient zur Durchführung des Unterbrechungstestes mittels kapazitiver Messung. Hierbei wird eine Leiterbahn lediglich mit einer einzigen Testelektrode 1 an einer ihrer Leiterplattentestpunkt elektrisch kontaktiert. Ein Messsignal mit einer vorbestimmten Frequenz wird eingespeist. Eine weitere Testelektrode 1 wird entweder mit einer parallel zur Leiterplatte 3 angeordneten ebenflächigen Testelektrode kontaktiert oder mit einer weiteren Leiterbahn der Leiterplatte 3 kontaktiert. Sowohl die Testelektrode als auch die weitere Leiterbahn 3 fungieren als eine Art Antenne bzw. Gegenelektrode zu der zu testenden Leiterbahn, in die ein durch das in den zu testenden Leiterbahnen eingespeistes Messsignal ein zu detektierendes Messsignal induziert wird, das von der dritten Auswerteeinrichtung 12 detektiert wird. Anhand dieses detektieren Messsignals kann die jeweilige Kapazität $C_i$ ermittelt werden. Im Rahmen der vorliegenden Erfindung wird als Kapazität auch ein komplexer Leitwert verstanden und als kapazitive Messung auch eine Messung des komplexen Leitwertes, sofern der komplexe Anteil des Leitwertes nicht gegen Null geht.

Beim erfindungsgemäßen Verfahren zum Testen von unbestückten, großflächigen Leiterplatten 3 werden die Leiterplatten in mehrere "virtuelle" Segmente unterteilt. In Fig. 2 ist eine Leiterplatte 3 dargestellt, in welcher schematisch vereinfacht einige wenige Leiterbahnen 2 eingezeichnet sind. Diese Leiterplatte weist eine Länge L von 900 mm und eine Breite B von 440 mm auf. Diese Leiterplatte ist in 3 Segmente I, II, III unterteilt, wobei sich das erste Segment I von der linken Begrenzungskante 320 mm nach rechts erstreckt und das dritte Segment III von der rechten Begrenzungskante 320 mm nach links erstreckt. Das zweite, bzw, mittlere Segment II ist im mittigen Bereich angeordnet und überlappt mit den beiden äußern Segmenten I und III jeweils in einem Überlappungsbereich von 40 mm. Das zweite Segmente II besitzt somit eine Bereite von 340 mm. Die Überlappungsbereiche 13 weisen somit eine Breite b von 40 mm auf.

Großflächige Leiterplatten besitzen eine typische Größe von z.B. 1200 mm x 600 mm, 800 mm x 1200 mm, 800 mm x 1500 mm oder 600 mm x 800 mm. Leiterplatten mit einer Fläche von weniger als 600 mm x 500 mm werden nicht als großflächige Leiterplatten betrachtet.

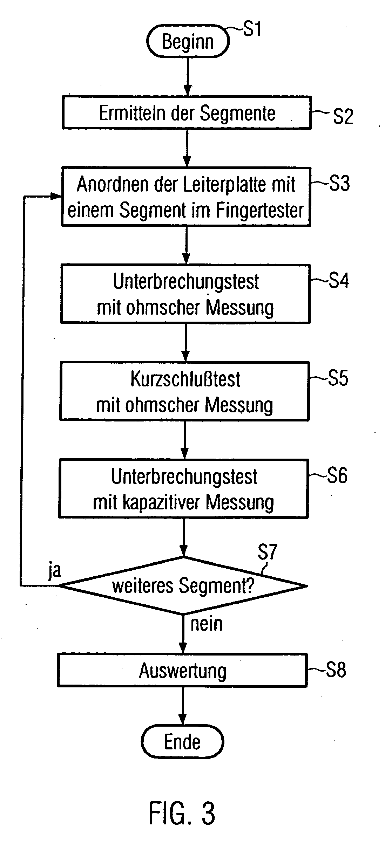

Nachfolgend wird das erfindungsgemäße Verfahren anhand des in Fig. 3 gezeigten Flussdiagramms näher erläutert.

Das Verfahren beginnt mit dem Schritt S1.

Im Schritt S2 werden die einzelnen Segmente ermittelt. Hierzu werden die Leiterbahnen der Leiterplatte 3 beschreibenden Daten (Gerber-Daten) verwendet, aus welchen ermittelt wird, wo die Grenzbereiche zwischen benachbarten Segmenten angeordnet werden können. Die entsprechenden Kriterien werden unten näher erläutert.

Im Schritt S3 wird die zu testende Leiterplatte 3 mit einem Segment I, H, III in einem Testbereich des Fingertesters angeordnet. Der Testbereich ist der gesamte Bereich, der von den Kontaktfingern 4 abgefahren werden kann und in dem die Testelektroden 1 die Leiterplatte 3 kontaktieren können. Der Testbereich weist typischerweise eine Größe von 600 mm x 600 mm auf.

Im Schritt S4 werden alle Leiterbahnen, die vollständig innerhalb dieses Segmentes liegen, bzw. deren Abschnitte vollständig innerhalb des jeweiligen Segmentes liegen mittels einer Ohmschen-Messung auf Unterbrechung getestet (S4). Im Segment I aus Fig. 2 liegen die Leiterbahnen 2/1, 2/2 und 2/5 vollständig innerhalb des Segmentes. Weiterhin liegt ein Abschnitt der Leiterbahn 2/4 vollständig innerhalb des Segmentes I. Dieser Abschnitt erstreckt sich von dem linken Endpunkt bzw. Leiterplattentestpunkt der Leiterbahn 2/4 bis zu dem Leiterplattentestpunkt der Leiterbahnen 2/4, der innerhalb des Überlappungsbereiches 13 liegt.

Danach werden die innerhalb des Segmentes liegenden Leiterbahnen auf herkömmliche Weise auf Kurzschluss mittels einer Ohmschen-Messung getestet (S5).

Im Schritt S6 werden die Leiterbahnen, die sich aus dem zu testenden Segment hinaus erstrecken und nicht abschnittsweise abgetastet werden können, wie z.B. die Leiterbahn 2/4, mittels kapazitiver Messung auf Unterbrechung getestet. Hierbei werden an allen Leiterplattentestpunkten, das sind die mit der jeweiligen Leiterbahn verbundenen Kontaktpunkte, die Kapazitätswerte der Leiterbahnen gemessen. Bei der in Fig. 2 gezeigten Leiterplatte 3 erstreckt sich die Leiterbahn 2/3 über alle Segmente. Von den Leiterplattentestpunkten, die mit dieser Leiterbahn 2/3 verbunden sind, werden die Kapazitätswerte erfasst.

Sind an einem Segment alle Messungen ausgeführt, so wird im Schritt S7 geprüft, ob ein weiteres Segment zu testen ist. Falls dies der Fall ist, geht der Verfahrensablauf auf den Schritt S3 über und die Leiterplatte wird mit dem weiteren Segment im Prüfbereich des Fingertesters angeordnet. Die Vorgänge gemäß den Schritten S4, S5, S6 werden entsprechend ausgeführt.

Wird im Schritt S7 festgestellt, dass in allen Segmenten die Messungen ausgeführt worden sind, geht der Verfahrensablauf auf den Schritt S8 über, in dem die Messergebnisse ausgewertet werden. Hier werden insbesondere die kapazitiven Messwerte ausgewertet. Die kapazitiven Messwerte einer Leiterbahn bilden jeweils eine Gruppe. Die Messwerte innerhalb einer Gruppe werden miteinander verglichen und falls sich zumindest ein Messwert von anderen Messwerten der jeweiligen Gruppe um einen vorbestimmten Wert um z.B. mehr als 0,5 % der elektrischen Kapazität unterscheidet, wird dies als Unterbrechung beurteilt. Es ist auch möglich, dass ein weiterer Vergleich mit einem vorgegebenen Referenzwert ausgeführt wird, der vorab mittels einer fehlerfreien Leiterplatte ("Golden Board") oder anhand eines Verfahrens, wie es in der EP 0 772 054 A2 erläutert ist, ermittelt worden ist.

Bei dem obigen Beispiel werden die Leiterbahnen 2/3 und 2/6 mittels kapazitiver Messung auf Unterbrechung getestet. Die übrigen Leiterbahnen 2/1, 2/2, 2/4, 2/5, 2/7 werden mit einer Ohmschen-Messung getestet. Die Leiterbahn 2/4 wird abschnittsweise beim Testen innerhalb der Segmente I und II getestet.

Die minimale Länge einer Leiterbahn, die kapazitiv auf Unterbrechungen getestet wird, ist bei den im Ausführungsbeispiel angeordneten Segmenten typischerweise 30 mm - 60 mm, was der Breite b der Überlappungsbereiche 13 entspricht. Die minimale Länge einer kapazitiv teilbaren Leiterplatte hängt von der elektrischen Kapazität der jeweiligen Leiterbahn ab, die wiederum von den verwendeten Materialien und dem Design der Leiterbahn abhängt.

Die elektrische Kapazität typischer Leiterbahnen liegt im Bereich weniger pF. Daher können bei den üblicherweise verwendeten Messfrequenzen von 2 kHz bis 64 kHz Widerstandswerte von zumindest 100 KΩ mit einer kapazitiven Messung detektiert werden. Der Zusammenhang zwischen der elektrischen Kapazität und des minimalen detektierbaren Widerstandes wird durch folgende Formel beschrieben:

$$R \approx \frac{1}{\omega \cdot C} \sqrt{\frac{1}{k} - 1},$$

wobei R der Widerstandswert, C die Kapazität, w die Kreisfrequenz ist und k = 0,07 gilt.

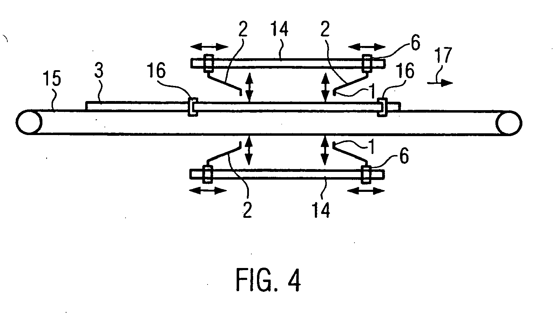

Fig. 4 zeigt schematisch vereinfacht eine Vorrichtung zum automatischen Testen von großflächigen Leiterplatten, die einen Fingertester mit Testelektroden 1, die jeweils an einen Schlitten 6 angeordnet sind, umfasst. Die Testelektroden 1 können zur Leiterplatte 3 hin und von der Leiterplatte 3 weg bewegt werden, um einzelne Leiterplattentestpunkte zu kontaktieren. Die Schlitten 6 sind an Traversen 14 horizontal verschiebbar angeordnet. Es ist jeweils eine Testeinheit mit Traverse 14, Schlitten 6 und Testelektroden 1 für die obere bzw. untere Seite einer zu testenden Leiterplatte 3 vorgesehen.

Zwischen diesen beiden Testeinheiten ist eine Fördereinrichtung zum Transportieren der zu testenden Leiterplatte 3 angeordnet. Diese Fördereinrichtung weist zwei schmale Förderbänder 15 auf, die zueinander parallel verlaufend angeordnet sind. Auf den Förderbändern 15 wird die zu testende Leiterplatte 3 aufgelegt.

Im Testbereich zwischen den beiden Testeinheiten sind Klemmeinrichtungen 16 angeordnet, mit welchen die zu testende Leiterplatte 3 im Testbereich bzw. zwischen den beiden Testeinheiten fixierbar ist. Die Klemmeinrichtungen sind automatisch öffnende und sich schließende Klemmen, so dass das Klemmen mittels der Steuereinrichtung automatisch ausführbar ist. Ist die Leiterplatte 3 mittels der Klemmeinrichtung 16 im Testbereich fixiert, werden die Förderbänder 15 etwas abgesenkt und seitlich aus dem Testbereich (in Richtung senkrecht zur Zeichenebene der Fig. 4) herausbewegt, so dass der Testbereich frei von den Förderbändern 15 ist. Danach können die Leiterplattentestpunkte eines Segmentes der Leiterplatte 3 getestet werden. Nach dem abschließenden Testen des Segmentes werden die Förderbänder 15 wieder unter die Leiterplatte 3 bewegt, die Klemmeinrichtung gelöst, die Leiterplatte 3 in Förderrichtung (pfeil 17) weiterbewegt um sie mit dem nächsten Segment im Testbereich zu positionieren. Somit ist es möglich, die mehreren Segmente einer Leiterplatte 3 automatisch aufeinanderfolgend zu testen.

Die Erfindung kann folgendermaßen kurz zusammengefasst werden:

Die Erfindung betrifft ein Verfahren zum Testen von unbestückten, großflächigen, Leiterbahnen aufweisenden Leiterplatte mit einem Fingertester.

Gemäß dem erfindungsgemäßen Verfahren werden die Leiterplatten in mehreren Segmenten unterteilt getestet, wobei Leiterbahnen, die sich über ein Segment hinaus erstrecken mittels kapazitiver Messung der in dem jeweiligen Segment befindlichen Endpunkte getestet werden, wobei eine Unterbrechung der Leiterbahn festgestellt wird, falls sich ein Messwert der zu einer Leiterbahn gehörenden kapazitiven Messwerte der sich von anderen Messwerten signifikant unterscheidet.

Mit dem erfindungsgemäßen Verfahren können somit Leiterplatten getestet werden, die größer als der Testbereich des Fingertesters sind, wobei die einzelnen Segmente aufeinanderfolgend im Testbereich des Fingertesters angeordnet werden. Die maximale Größe der einzelnen Segmente entspricht dem Testbereich des jeweiligen Fingertesters. Hierdurch ist es nicht notwendig, einen speziellen Fingertester für großflächige Leiterplatten vorzusehen, der wesentlich teurer ist, als Fingertester in einem Testbereich mit Standardgröße.

Beim erfindungsgemäßen Verfahren kann eine zu testende Leiterplatte mit den Segmenten, die nicht getestet werden, am Testbereich des Fingertesters überstehen.

Bezugszeichenliste

1 Testelektrode
2 Leiterbahn
3 Leiterplatte
4 Kontaktfinger
5 Positionssteuereinrichtung
6 Schlitten
7 Stellzylinder
8 zentrale Steuereinheit
9 Funktionsgenerator
10 erste Auswerteeinrichtung
11 zweite Auswerteeinrichtung
12 dritte Auswerteeinrichtung
13 Überlappungsbereich
14 Traverse
15 Förderband
16 Klemmeinrichtung
17 Pfeil

**Patentansprüche**

1. Verfahren zum Testen von unbestückten, großflächigen Leiterbahnen aufweisenden Leiterplatten mit einem Fingertester, wobei

    - die Leiterplatte (3) in mehrere Segmente (I, II, III) unterteilt getestet wird, wobei die einzelnen Segmente (I, II, III) aufeinanderfolgend in einem Testbereich des Fingertesters getestet werden, bis die vollständige Leiterplatte (3) getestet worden ist, wobei der Testbereich der gesamte Bereich ist, der von Kontaktfingern (4) des Fingertesters abgefahren werden kann und in dem Testelektroden (1) der Kontaktfinger (4) die Leiterplatte (3) kontaktieren können, und die Leiterplatte (3) größer als der Testbereich ist, und
    - beim Testen jeweils eines Segmentes (I, II, III) der Leiterplatte (3) Leiterbahnen (2), die sich über das jeweilige zu testende Segment hinaus erstrecken, mittels kapazitiver Messung der in dem Segment befindlichen Endpunkte dieser Leiterbahnen (2) auf Unterbrechungen getestet werden, wobei jeweils ein kapazitiver Messwert erfasst wird,
    - nach dem abschließenden Testen des einen Segmentes (I, II, III) die Leiterplatte (3) weiterbewegt wird, um sie mit den nächsten Segment (I, II, III) im Testbereich zu positionieren,
    - alle zu einer Leiterbahn (2) gehörenden kapazitiven Messwerte jeweils eine Gruppe bilden und die kapazitiven Messwerte innerhalb einer jeden Gruppe miteinander verglichen werden, und falls sich zumindest ein kapazitiver Messwert von anderen kapazitiven Messwerten der jeweiligen Gruppe um einen vorbestimmten Wert unterscheidet, wird dies als Unterbrechung beurteilt.

2. Verfahren nach Anspruch 1,
**dadurch gekennzeichnet,**
**dass** die Segmente (I, II, III) derart überlappend angeordnet werden, dass alle Leiterbahnen (2) mit einer maximalen Länge von 40 mm bis 60mm jeweils vollständig innerhalb eines Segmentes (I, II, III) liegen.

3. Verfahren nach Anspruch 2,
**dadurch gekennzeichnet,**
**dass** die Segmente in einem streifenförmigen Bereich mit einer Breite von 20 mm bis 100 mm überlappen.

**4.** Verfahren nach Anspruch 1 oder 2,
**dadurch gekennzeichnet,**
**dass** Leiterbahnen (2) auf einer maximalen Länge von 40 mm bis 60 mm auf Unterbrechungen mittels einer Ohmschen-Messung untersucht werden.

**5.** Verfahren nach einem der Ansprüche 1 bis 3,
**dadurch gekennzeichnet,**
**dass** alle Leiterbahnen (2), die vollständig innerhalb eines Segmentes (I, II, III) liegen, auf Unterbrechungen mittels einer Ohmschen-Messung untersucht werden.

**6.** Verfahren nach einem der Ansprüche 1 bis 5,
**dadurch gekennzeichnet,**
**dass** ein Segment ein Größe von etwa 200 mm x 200 mm bis 600 mm x 500 mm aufweist.

**7.** Verfahren nach einem der Ansprüche 1 bis 6,
**dadurch gekennzeichnet,**
**dass** Leiterplatten (3) mit einer Größe von mehr als 600 mm x 500 mm bis 800 mm x 1500 mm getestet werden.

**8.** Verfahren nach einem der Ansprüche 1 bis 8,
**dadurch gekennzeichnet,**
**dass** der vorbestimmte Wert, mit welchem sich ein Messwert einer Gruppe von den anderen Messwerten unterscheiden muss, damit die Leiterbahn als unterbrochen beurteilt wird, 0,5 % der elektrischen Kapazität der Messwerte beträgt.

**9.** Vorrichtung zum Testen von unbestückten, großflächigen, Leiterbahnen aufweisenden Leiterplatten, umfassend einen Fingertester und eine Steuereinrichtung die zum Ausführen des Verfahrens nach einem der Ansprüche 1 bis 8 ausgebildet ist.

**10.** Vorrichtung nach Anspruch 9,
**dadurch gekennzeichnet,**
**dass** die Vorrichtung eine Fördereinrichtung zum automatischen Bewegen der zu testenden Leiterplatten eine Klemmeinrichtung (16) zum Fixieren der Leiterplatten in einem Testbereich des Fingertesters aufweist.

## Claims

**1.** Method of testing non-componented, circuit boards with extensive conductor paths using a finger tester, wherein

- the circuit board (3) is tested in several segments (I, II, III), wherein the individual segments (I, II, III) are tested consecutively in one testing area of the finger tester, until the complete circuit board (3) has been tested, wherein the testing area is the whole area which can be traced by contact fingers (4) of the finger tester and in which test electrodes (1) of the contact fingers (4) can contact the circuit board (3), and the circuit board (3) is larger than the testing area, and
- in testing each segment (I, II, III) of the circuit board (3), conductor paths (2) which extend beyond the respective segment to be tested are tested for open-circuits by means of capacitive measurement of the end points of these conductor paths (2) located in the segment, wherein a capacitive measured value is recorded in each case,
- after the final testing of one segment (I, II, III), the circuit board (3) is moved on, so as to position it with the next segment (I, II, III) in the testing area,
- all capacitive measured values belonging to a conductor path (2) in each case form a group, and the capacitive measured values within each group are compared with one another, and if at least one capacitive measured value differs from other capacitive measured values of that group by a predetermined value, this is judged to be an open-circuit.

**2.** Method according to claim 1,
**characterised in that**
the segments (I, II, III) are arranged to overlap in such a way that all conductor paths (2) with a maximum length of 40 mm to 60 mm lie in each case completely within a segment (I, II, III).

**3.** Method according to claim 2,
**characterised in that**
the segments overlap in a strip-like zone with a width of 20 mm to 100 mm.

**4.** Method according to claim 1 or 2,
**characterised in that**
conductor paths (2) to a maximum length of 40 mm to 60 mm are tested for open-circuits by means of ohmic measurement.

**5.** Method according to any of claims 1 to 3,
**characterised in that**
all conductor paths (2) lying completely within a segment (I, II, III) are tested for open-circuits by means of ohmic measurement.

**6.** Method according to any of claims 1 to 5,
**characterised in that**
a segment has a size of around 200 mm x 200 mm up to 600 mm x 500 mm.

**7.** Method according to any of claims 1 to 6,
**characterised in that**
circuit boards (3) with a size of more than 600 mm x 500 mm to 800 mm x 1500 mm are tested.

8. Method according to any of claims 1 to 8, **characterised in that** the predetermined value by which a measured value of a group must differ from the other measured values, for the conductor path to be judged to be open-circuit, is 0.5% of the electrical capacity of the measured values.

9. Apparatus for the testing of non-componented circuit boards with extensive conductor paths, comprising a finger tester and a control unit designed to implement the method according to any of claims 1 to 8.

10. Apparatus according to claim 9, **characterised in that** the apparatus has a conveyor for the automatic movement of the circuit boards to be tested, and a clamping device (16) for locating the circuit boards in a testing area of the finger tester.

**Revendications**

1. Procédé pour tester des cartes à circuits imprimés non garnies présentant des pistes conductrices de grande surface, au moyen d'un testeur à pattes, dans lequel

   - la carte à circuits imprimés (3) est testée de façon subdivisée en plusieurs segments (I, II, III), tels que les segments individuels (I, II, III) sont testés les uns après les autres dans une zone de test du testeur à pattes, jusqu'à ce que la totalité de la carte à circuits imprimés (3) ait été testée, et la zone de test est la totalité de la zone qui peut être atteinte par les pattes de contact (4) du testeur à pattes et dans lequel des électrodes de test (1) des pattes de contact (4) peuvent venir en contact avec la carte à circuits imprimés (3), et la carte à circuits imprimés (3) est plus grande que la zone de test, et
   - lorsqu'on teste un segment respectif (I, II, III) de la carte à circuits imprimés (3), des pistes conductrices (3) qui s'étendent au-delà du segment respectif qu'il s'agit de tester sont testées au moyen d'une mesure capacitive des points terminaux, qui se trouvent dans ce segment, de ces pistes conductrices (2) vis-à-vis d'interruptions, et l'on détecte respectivement une valeur de mesure capacitive,
   - après achèvement d'un test d'un segment (I, II, III), la carte à circuits imprimés (3) est déplacée plus loin afin de la positionner avec le segment suivant (I, II, III) dans la zone de test,
   - toutes les valeurs de mesure capacitive appartenant à une piste conductrice (2) forment respectivement un groupe et les valeurs de mesure capacitive à l'intérieur de chaque groupe sont comparées les unes aux autres, et si au moins une valeur de mesure capacitive se distingue des autres valeurs de mesure capacitive du groupe respectif d'une valeur prédéterminée, ceci est interprété comme une interruption.

2. Procédé selon la revendication 1, **caractérisé en ce que** les segments (I, II, III) sont agencés en chevauchement de telle manière que toutes les pistes conductrices (2) avec une longueur maximum de 40 mm à 60 mm se trouvent respectivement totalement à l'intérieur d'un segment (I, II, III).

3. Procédé selon la revendication 2, **caractérisé en ce que** les segments se chevauchent dans une zone en forme de bande d'une largeur de 20 mm à 100 mm.

4. Procédé selon la revendication 1 ou 2, **caractérisé en ce que** des pistes conductrices (2) sont examinées sur une longueur maximum de 40 mm à 60 mm au moyen d'une mesure ohmique pour détecter des interruptions.

5. Procédé selon l'une des revendications 1 à 3, **caractérisé en ce que** toutes les pistes conductrices (3) qui se trouvent entièrement à l'intérieur d'un segment (I, II, III) sont examinées au moyen d'une mesure ohmique pour détecter des interruptions.

6. Procédé selon l'une des revendications 1 à 5, **caractérisé en ce qu'**un segment a une taille d'environ 200 mm x 200 mm à 600 mm x 600 mm.

7. Procédé selon l'une des revendications 1 à 6, **caractérisé en ce que** des cartes à circuits imprimés (3) avec une taille de plus de 600 mm x 500 mm jusqu'à 800 mm x 1500 mm sont testés.

8. Procédé selon l'une des revendications 1 à 8, **caractérisé en ce que** la valeur prédéterminée de laquelle une valeur de mesure d'un groupe doit se distinguer des autres valeurs de mesure afin de conclure que la piste conductrice est interrompue, s'élève à 0,5 % de la capacité électrique des valeurs de mesure.

9. Dispositif pour tester des cartes à circuits imprimés non garnies, présentant des pistes conductrices de grande surface, comprenant un testeur à pattes et un système de commande qui est réalisé pour mettre en oeuvre le procédé selon l'une des revendications 1 à 8.

10. Dispositif selon la revendication 9,

**caractérisé en ce que** le dispositif comprend un moyen de convoyage pour déplacer automatiquement les cartes à circuits imprimés à tester, et un moyen de serrage (16) pour fixer les cartes à circuits imprimés dans une zone de test du testeur à pattes.

FIG. 1

FIG. 2

```
                    ╭─────────╮ ⌐S1
                    │ Beginn  │
                    ╰─────────╯
                         │
                         ▼
          ┌──────────────────────────┐
          │  Ermitteln der Segmente  │⌐S2
          └──────────────────────────┘
                         │
                         ▼
          ┌──────────────────────────┐
          │ Anordnen der Leiterplatte mit │⌐S3
     ┌───▶│ einem Segment im Fingertester │
     │    └──────────────────────────┘
     │                   │
     │                   ▼
     │    ┌──────────────────────────┐
     │    │   Unterbrechungstest     │⌐S4
     │    │   mit ohmscher Messung   │
     │    └──────────────────────────┘
     │                   │
     │                   ▼
     │    ┌──────────────────────────┐
     │    │    Kurzschlußtest        │⌐S5
     │    │   mit ohmscher Messung   │
     │    └──────────────────────────┘
     │                   │
     │                   ▼
     │    ┌──────────────────────────┐
     │    │   Unterbrechungstest     │⌐S6
     │    │  mit kapazitiver Messung │
     │    └──────────────────────────┘
     │                   │
     │                   ▼        S7
     │  ja   ╱◇◇◇◇◇◇◇◇◇◇◇◇◇◇◇╲
     └──────◇ weiteres Segment? ◇
            ╲◇◇◇◇◇◇◇◇◇◇◇◇◇◇◇╱
                         │ nein
                         ▼
          ┌──────────────────────────┐
          │        Auswertung        │⌐S8
          └──────────────────────────┘
                         │
                         ▼
                    ╭─────────╮
                    │  Ende   │
                    ╰─────────╯
```

# FIG. 3

FIG. 4

## IN DER BESCHREIBUNG AUFGEFÜHRTE DOKUMENTE

**In der Beschreibung aufgeführte Patentdokumente**

- WO 0140809 A1
- US 5045783 A
- EP 0468153 A1
- US 3975680 A
- EP 0772054 A2
- US 4565966 A
- EP 0468135 A1